# EUROPEAN PATENT APPLICATION

(11) **EP 1 557 719 A2**
(43) Date of publication of application: **27.07.2005**
(21) Application number: 05001274.9
(22) Date of filing: 21.01.2005
(51) Int. Cl.: G03F 7/039

(54) **Chemically amplified resist and pattern formation method**

(30) Priority: 26.01.2004 JP 2004017370; 26.01.2004 JP 2004017379
(71) Applicant: MATSUSHITA ELECTRIC INDUSTRIAL CO., LTD., Kadoma-shi, Osaka 571-8501 (JP)
(72) Inventor: Endo, Masayuki, Kishiwada-shi Osaka 596-0825 (JP); Sasago, Masaru, Hirakata-shi Osaka 573-0007 (JP)
(74) Representative: Grünecker, Kinkeldey, Stockmair & Schwanhäusser Anwaltssozietät

(57) **Abstract**

A resist film made of a chemically amplified resist including a water-soluble polymer is formed on a substrate, whereas the water-soluble polymer has lower gas permeability than the chemically amplified resist. Subsequently, pattern exposure is carried out by selectively irradiating the resist film with exposing light through a mask, and thereafter, the resultant resist film is developed. Thus, a fine resist pattern made of the resist film is formed in a good shape.

## Description

### CROSS-REFERENCE TO RELATED APPLICATIONS

This application claims priority under 35 U.S.C. §119 on Patent Application Nos. 2004-17370 and 2004-17379 both filed in Japan on January 26, 2004, the entire contents of which are hereby incorporated by reference.

### BACKGROUND OF THE INVENTION

The present invention relates to a chemically amplified resist used in pattern formation in fabrication process or the like for semiconductor devices and a pattern formation method using the same.

In accordance with the increased degree of integration of semiconductor integrated circuits and downsizing of semiconductor devices, there are increasing demands for further faster development of lithography technique. Pattern formation is currently carried out through photolithography using exposing light of a mercury lamp, KrF excimer laser, ArF excimer laser or the like. Also, in order to form a fine pattern with exposing light of a wavelength of 0.1 µm or less, and more particularly, of 70 nm or less, examinations are being made on application of a shorter wavelength, such as vacuum UV like F₂ laser of a wavelength of a 157 nm band or extreme UV of a wavelength of a 1 nm through 30 nm band. Furthermore, application of electron beams of electron beam (EB) projection exposure is being examined.

In the case where the vacuum UV such as F₂ laser or the electron beam is used as the exposing light source, it is necessary to reduce outgassing from a resist during exposure. A gas outgassed in the exposure is adhered onto a lens, mirror or the like included in an exposure system or a mask, and hence, it is apprehended that the illuminance is lowered, the accuracy of a desired pattern is degraded or the throughput is lowered (see, for example, S. Hien et al., "Photoresist Outgassing at 157 nm Exposure", Proc. SPIE, Vol. 4345, p. 439 (2001)).

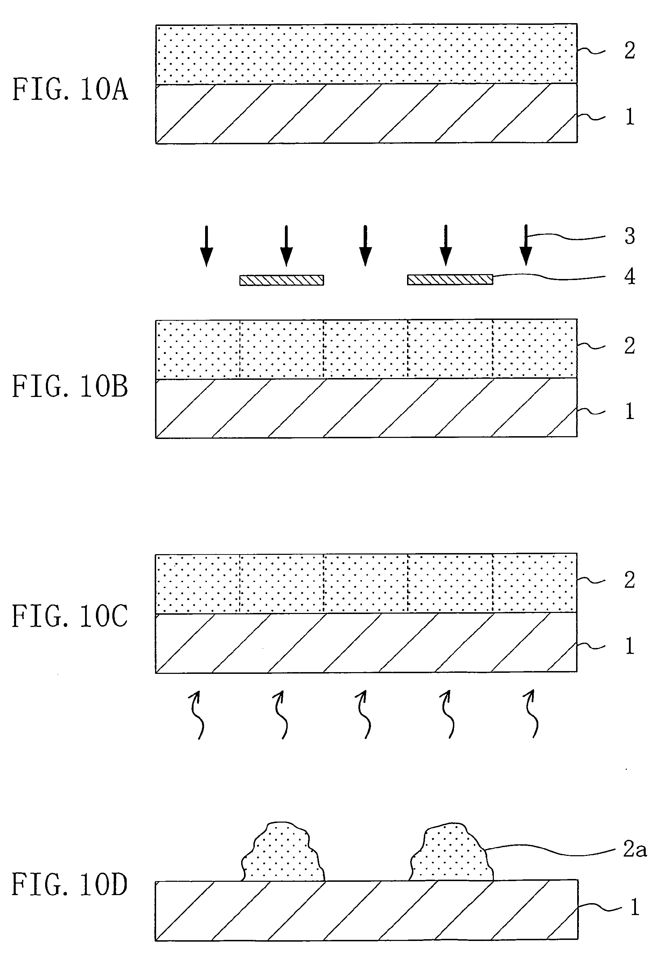

Now, a conventional pattern formation method using F₂ laser as the exposing light will be described with reference to FIGS. **10A** through **10D**.

First, a positive chemically amplified resist material having the following composition is prepared:
Base polymer: poly(styrenehexafluoroisopropyl alcohol) (40 mol%) - (α-trifluoromethyl-t-butylacrylate) (60 mol%)) ... 2 g
Acid generator: triphenylsulfonium triflate ... 0.08 g
Solvent: propylene glycol monomethyl ether acetate ... 20 g

Next, as shown in FIG. **10A,** the aforementioned chemically amplified resist material is applied on a substrate 1 so as to form a resist film **2** with a thickness of 0.15 µm.

Then, as shown in FIG. **10B**, pattern exposure is carried out by irradiating the resist film **2** with exposing light **3** of F₂ laser with numerical aperture (NA) of 0.85 through a mask **4.**

After the pattern exposure, as shown in FIG. **10C,** the resist film **2** is baked with a hot plate at a temperature of 110°C for 60 seconds (post exposure bake).

Next, the resultant resist film **2** is developed with a 2.38 wt% tetramethylammonium hydroxide aqueous solution (alkaline developer). In this manner, a resist pattern **2a** made of an unexposed portion of the resist film **2** and having a line width of 0.08 µm is formed as shown in FIG. **10D**.

### SUMMARY OF THE INVENTION

However, as shown in FIG. **10D**, the resist pattern **2a** formed by the conventional pattern formation method is in a defective shape. This pattern failure seems to be caused because of outgassing from the resist film **2** made of the chemically amplified resist irradiated with the exposing light and the thus generated gas is adhered onto a lens and the like. Such a gas generated from the resist is mainly derived from vaporization of an acid labile group included in the chemically amplified resist.

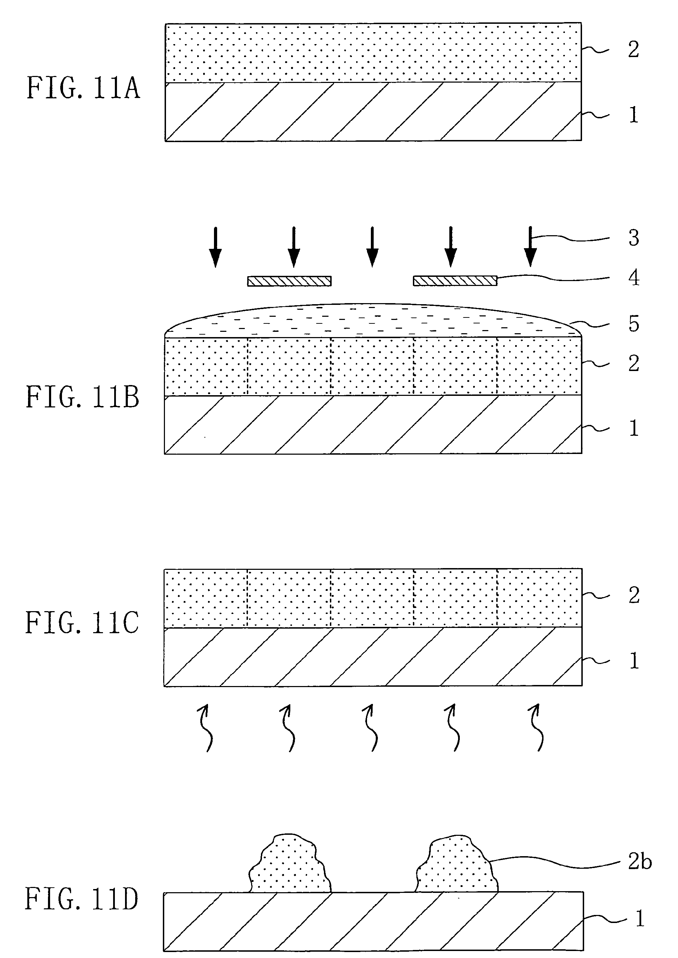

Furthermore, also in immersion lithography (see M. Switkes and M. Rothschild, "Immersion lithography at 157 nm", J. Vac. Sci. Technol. Vol. B19, p. 2353 (2001)) in which the pattern exposure is carried out with an immersion liquid **5** for increasing the value of the numerical aperture of exposing light **3** filled in a space between a projection lens (not shown) of an exposure system and a resist film **2** formed on a substrate **1** as shown in FIG. **11B**, a resultant resist pattern **2b** is in a defective shape as shown in FIG. **11D.** In this case, a gas is outgassed from the resist film **2** made of a chemically amplified resist irradiated with the exposing light in the exposure, and the thus generated gas forms foams within the liquid **5**. These foams formed in the liquid **5** causes, for example, diffraction of the exposing light **3**, and hence, the resultant pattern is in a defective shape.

When the resist pattern **2b** in such a defective shape is used for etching a target film, the resultant pattern of the target film is also in a defective shape, resulting in disadvantageously lowering the productivity and the yield in the fabrication process of semiconductor devices.

In consideration of the aforementioned conventional problem, an object of the invention is forming a fine pattern in a good shape by preventing a gas outgassed from a resist through irradiation with exposing light from reaching members provided in an exposure system.

The present inventors have made various examinations for preventing outgassing from a resist through irradiation with exposing light, resulting in finding the following: When a water-soluble polymer with lower gas permeability than a chemically amplified resist is included in the chemically amplified resist or is deposited on the chemically amplified resist, the trouble caused in members of an exposure system such as a lens and a liquid by outgassing from a resist irradiated with exposing light can be prevented.

The present invention was devised on the basis of this finding, and according to the invention, a gas outgassed from a resist film can be prevented from reaching a lens or a liquid by including, in a chemically amplified resist, a water-soluble polymer with lower gas permeability than the chemically amplified resist or by forming a film of the water-soluble polymer on the resist film. Specifically, the present invention is practiced as follows:

The chemically amplified resist of this invention includes a water-soluble polymer having lower gas permeability than the chemically amplified resist excluding the water-soluble polymer.

Since the chemically amplified resist of this invention includes the water-soluble polymer having lower gas permeability than the chemically amplified resist excluding the water-soluble polymer, even when outgassing is caused in the chemically amplified resist through irradiation with exposing light, the thus generated gas minimally permeates the water-soluble polymer within the resist and hence is substantially captured by the water-soluble polymer. Accordingly, the gas outgassed from the chemically amplified resist minimally reaches optical members such as a lens of an exposure system and a mask, so as to avoid the trouble of the exposure system and the mask. As a result, a fine pattern can be formed in a good shape.

The content of the water-soluble polymer in the chemically amplified resist may be approximately 0.1 wt% through 10 wt% for attaining a sufficient effect, but the content is not limited to this range but may be increased/reduced depending upon the compositions of the chemically amplified resist and the water-soluble polymer.

The first pattern formation method of this invention includes the steps of forming, on a substrate, a resist film made of a chemically amplified resist including a water-soluble polymer; performing pattern exposure by selectively irradiating the resist film with exposing light; and forming a resist pattern made of the resist film by developing the resist film after the pattern exposure, and the water-soluble film has lower gas permeability than the chemically amplified resist excluding the water-soluble polymer.

In the first pattern formation method, even when outgassing from the chemically amplified resist is caused through irradiation with the exposing light in the step of performing the pattern exposure, the thus generated gas minimally permeates the water-soluble polymer within the resist and hence is substantially captured by the water-soluble polymer. Accordingly, the gas outgassed from the chemically amplified resist minimally reaches optical members such as a lens of an exposure system and a mask, and hence the trouble of the exposure system and the mask can be avoided. As a result, a fine resist pattern can be formed in a good shape.

The second pattern formation method of this invention includes the steps of forming, on a substrate, a resist film made of a chemically amplified resist; forming, on the resist film, a water-soluble film containing a water-soluble polymer having lower gas permeability than the chemically amplified resist; performing pattern exposure by selectively irradiating the resist film with exposing light through the water-soluble film; and forming a resist pattern made of the resist film by developing the resist film after removing the water-soluble film after the pattern exposure.

In the second pattern formation method, even when outgassing from the chemically amplified resist is caused through irradiation with the exposing light in the step of performing the pattern exposure, the thus generated gas minimally permeates the water-soluble film containing the water-soluble polymer formed on the resist film and hence is substantially captured by the water-soluble film. Accordingly, the gas outgassed from the chemically amplified resist minimally reaches optical members such as a lens of an exposure system and a mask, and hence the trouble of the exposure system and the mask can be avoided. As a result, a fine resist pattern can be formed in a good shape.

The third pattern formation method of this invention includes the steps of forming, on a substrate, a resist film made of a chemically amplified resist; forming, on the resist film, a water-soluble film containing a water-soluble polymer having lower gas permeability than the chemically amplified resist; performing pattern exposure by selectively irradiating the resist film with exposing light through the water-soluble film; and removing the water-soluble film and forming a resist pattern made of the resist film by developing the resist film after the pattern exposure.

In the third pattern formation method, even when outgassing from the chemically amplified resist is caused through irradiation with the exposing light in the step of performing the pattern exposure, the thus generated gas minimally permeates the water-soluble film made of the water-soluble polymer formed on the resist film and hence is substantially captured by the water-soluble film. Accordingly, the gas outgassed from the chemically amplified resist minimally reaches optical members such as a lens of an exposure system and a mask, and hence the trouble of the exposure system and the mask can be avoided. As a result, a fine resist pattern can be formed in a good shape.

The water-soluble film formed on the resist film is removed before the development in the second pattern formation method while it is removed during the development in the third pattern formation method. In the second pattern formation method, since the water-soluble film is removed before the development, the development is proceeded in a general manner. Alternatively, since the water-soluble film is removed during the development in the third pattern formation method, the dissolving characteristic of the resist can be controlled, resulting in improving the dissolving characteristic of the resist. The control of the dissolving characteristic will be described later.

The exposing light may be KrF excimer laser, ArF excimer laser, F₂ laser, ArKr laser, Ar₂ laser, extreme UV of a wavelength band not shorter than 1. nm and not longer than 30 nm, or electron beams.

The fourth pattern formation method of this invention includes the steps of forming, on a substrate, a resist film made of a chemically amplified resist including a water-soluble polymer; performing pattern exposure by selectively irradiating the resist film with exposing light with a liquid provided on the resist film; and forming a resist pattern made of the resist film by developing the resist film after the pattern exposure, and the water-soluble polymer has lower gas permeability than the chemically amplified resist excluding the water-soluble polymer.

In the fourth pattern formation method, even when outgassing from the chemically amplified resist is caused through irradiation with the exposing light in the step of performing the pattern exposure, the thus generated gas minimally permeates the water-soluble polymer within the resist film and hence is substantially captured by the water-soluble polymer. Accordingly, the gas outgassed from the chemically amplified resist minimally reaches the liquid, and hence foams derived from outgassing are not formed. Thus, the exposing light is not affected by the foams, and as a result, a fine resist pattern can be formed in a good shape.

The content of the water-soluble polymer in the chemically amplified resist is approximately 0.1 wt% through 10wt% for attaining a sufficient effect, but the content is not limited to this range but may be increased/reduced depending upon the composition of the chemically amplified resist or the water-soluble polymer.

The fifth pattern formation method of this invention includes the steps of forming, on a substrate, a resist film made of a chemically amplified resist; forming, on the resist film, a water-soluble film containing a water-soluble polymer having lower gas permeability than the chemically amplified resist; performing pattern exposure by selectively irradiating the resist film with exposing light through the water-soluble film with a liquid provided on the water-soluble film; and forming a resist pattern made of the resist film by developing the resist film after removing the water-soluble film after the pattern exposure.

In the fifth pattern formation method, even when outgassing from the chemically amplified resist is caused through irradiation with the exposing light in the step of performing the pattern exposure through the immersion liquid, the thus generated gas minimally permeates the water-soluble film made of the water-soluble polymer formed on the resist film and hence is substantially captured by the water-soluble film. Accordingly, the gas outgassed from the chemically amplified resist minimally reaches the liquid, and hence foams derived from outgassing are not formed. Thus, the exposing light is not affected by the foams, and as a result, a fine resist pattern can be formed in a good shape.

The sixth pattern formation method of this invention includes the steps of forming, on a substrate, a resist film made of a chemically amplified resist; forming, on the resist film, a water-soluble film containing a water-soluble polymer having lower gas permeability than the chemically amplified resist; performing pattern exposure by selectively irradiating the resist film with exposing light through the water-soluble film with a liquid provided on the water-soluble film; and removing the water-soluble film and forming a resist pattern made of the resist film by developing the resist film after the pattern exposure.

In the sixth pattern formation method, even when outgassing from the chemically amplified resist is caused through irradiation with the exposing light in the step of performing the pattern exposure through the immersion liquid, the thus generated gas minimally permeates the water-soluble film made of the water-soluble polymer formed on the resist film and hence is substantially captured by the water-soluble film. Accordingly, the gas outgassed from the chemically amplified resist minimally reaches the liquid, and hence foams derived from outgassing are not formed. Thus, the exposing light is not affected by the foams, and as a result, a fine resist pattern can be formed in a good shape.

The water-soluble film formed on the resist film is removed before the development in the fifth pattern formation method while it is removed during the development in the sixth pattern formation method. In the fifth pattern formation method, since the water-soluble film is removed before the development, the development is proceeded in a general manner. Alternatively, since the water-soluble film is removed during the development in the sixth pattern formation method, the dissolving characteristic of the resist can be controlled, resulting in improving the dissolving characteristic of the resist. The control of the dissolving characteristic will be described later.

In the fourth pattern formation method, the liquid may be water or perfluoropolyether.

In the fifth or sixth pattern formation method, the liquid may be a non-aqueous solution such as perfluoropolyether.

Also, the exposing light may be KrF excimer laser, ArF excimer laser, F₂ laser, ArKr laser or Ar₂ laser.

In each of the second, third, fifth and sixths pattern formation methods, the chemically amplified resist preferably includes a water-soluble polymer having lower gas permeability than the chemically amplified resist excluding the water-soluble polymer. Thus, the gas outgassed from the chemically amplified resist during the exposure can be more effectively prevented from reaching the members of the exposing system, the mask or the liquid.

In the chemically amplified resist and each pattern formation method using the same according to this invention, the water-soluble polymer may be at least one of polyacrylic acid, polystyrenesulfonic acid, hydroxyethyl cellulose, polyisoprenesulfonic acid, polyvinyl pyrrolidone and pullulan.

### BRIEF DESCRIPTION OF THE DRAWINGS

FIGS. **1A, 1B, 1C** and **1D** are cross-sectional views for showing procedures in a pattern formation method according to Embodiment 1 of the invention;
FIGS. **2A, 2B, 2C** and **2D** are cross-sectional views for showing procedures in a pattern formation method according to Embodiment 2 of the invention;
FIGS. **3A** and **3B** are cross-sectional views for showing other procedures in the pattern formation method of Embodiment 2;
FIGS. **4A, 4B, 4C, 4D** and **4E** are cross-sectional views for showing procedures in a pattern formation method according to Embodiment 3 of the invention;
FIGS. **5A, 5B, 5C** and **5D** are cross-sectional views for showing procedures in a pattern formation method according to Embodiment 4;
FIGS. **6A, 6B, 6C** and **6D** are cross-sectional views for showing procedures in a pattern formation method according to Embodiment 5 of the invention;
FIGS. **7A** and **7B** are cross-sectional views for showing other procedures in the pattern formation method of Embodiment 5;
FIGS. **8A, 8B, 8C, 8D** and **8E** are cross-sectional views for showing procedures in a pattern formation method according to Embodiment 6 of the invention;
**FIG. 9** is a graph for explaining control of solubility of a resist in the pattern formation method of Embodiments 3 and 6;
FIGS. **10A, 10B, 10C** and **10D** are cross-sectional views for showing procedures in a conventional pattern formation method; and
FIGS. **11A, 11B, 11C** and **11D** are cross-sectional views for showing procedures in a conventional pattern formation method employing immersion lithography.

### DETAILED DESCRIPTION OF THE INVENTION

### EMBODIMENT 1

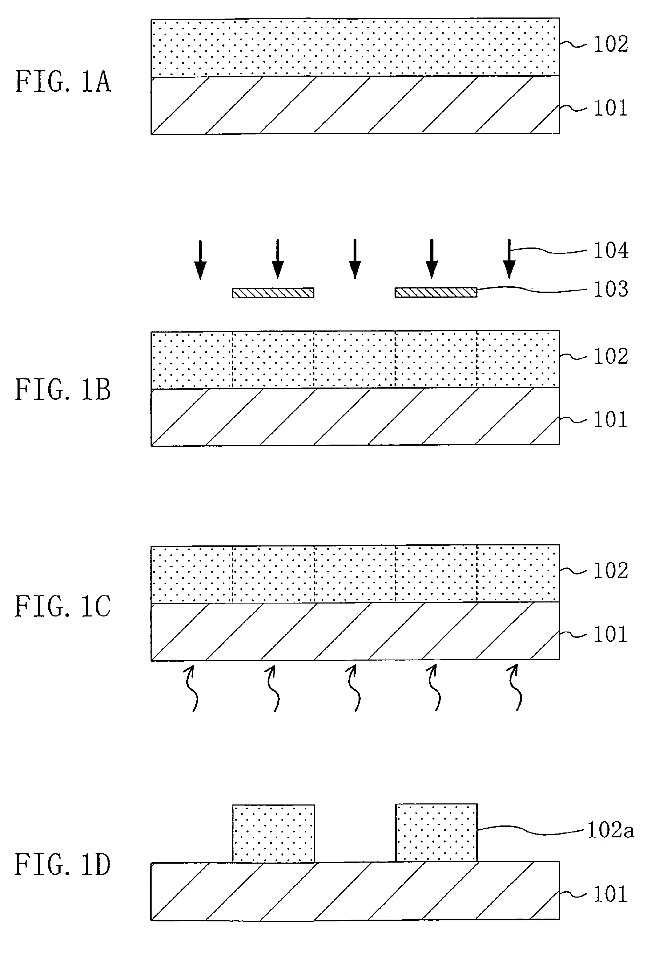

A pattern formation method using a water-soluble material according to Embodiment 1 of the invention will now be described with reference to FIGS. **1A** through **1D**.

First, a positive chemically amplified resist material having the following composition is prepared:
Base polymer: poly((styrenehexafluoroisopropyl alcohol) (40 mol%) - (α-trifluoromethyl-t-butylacrylate) (60 mol%)) ... 2 g
Water-soluble polymer: polyvinyl pyrrolidone ... 0.1 g
Acid generator: triphenylsulfonium triflate ... 0.08 g
Solvent: propylene glycol monomethyl ether acetate ... 20 g

Next, as shown in FIG. **1A**, the aforementioned chemically amplified resist material is applied on a substrate **101** so as to form a resist film **102** with a thickness of 0.15 µm.

Then, as shown in FIG. **1B**, pattern exposure is carried out by irradiating the resist film 102 with exposing light **104** of F₂ laser with numerical aperture (NA) of 0.85 through a mask 103.

After the pattern exposure, as shown in FIG. **1C,** the resist film **102** is baked with a hot plate at a temperature of 110°C for 60 seconds (post exposure bake).

Next, the resultant resist film **102** is developed with a 2.38 wt% tetramethylammonium hydroxide aqueous solution (alkaline developer). In this manner, a resist pattern **102a** made of an unexposed portion of the resist film **102** and having a line width of 0.08 µm is formed in a good shape as shown in FIG. **1D**.

In this manner, according to the pattern formation method of Embodiment 1, in the step of forming the resist film shown in FIG. **1A**, the resist material for the resist film **102** includes polyvinyl pyrrolidone with lower gas permeability than the chemically amplified resist excluding the water-soluble polymer (i.e., polyvinyl pyrrolidone). Therefore, in the step of pattern exposure shown in FIG. **1B**, outgassing from the resist film **102** is reduced to an undetectable level. Accordingly, a gas is not adhered onto a lens and a mirror included in an exposure system (not shown), the mask **103** and the like, resulting in forming the fine resist pattern **102a** in a good shape.

The water-soluble polymer included in the chemically amplified resist is not limited to polyvinyl pyrrolidone but at least one of polyvinyl pyrrolidone, polyacrylic acid, polystyrenesulfonic acid, hydroxyethyl cellulose, polyisoprenesulfonic acid and pullulan may be used.

### EMBODIMENT 2

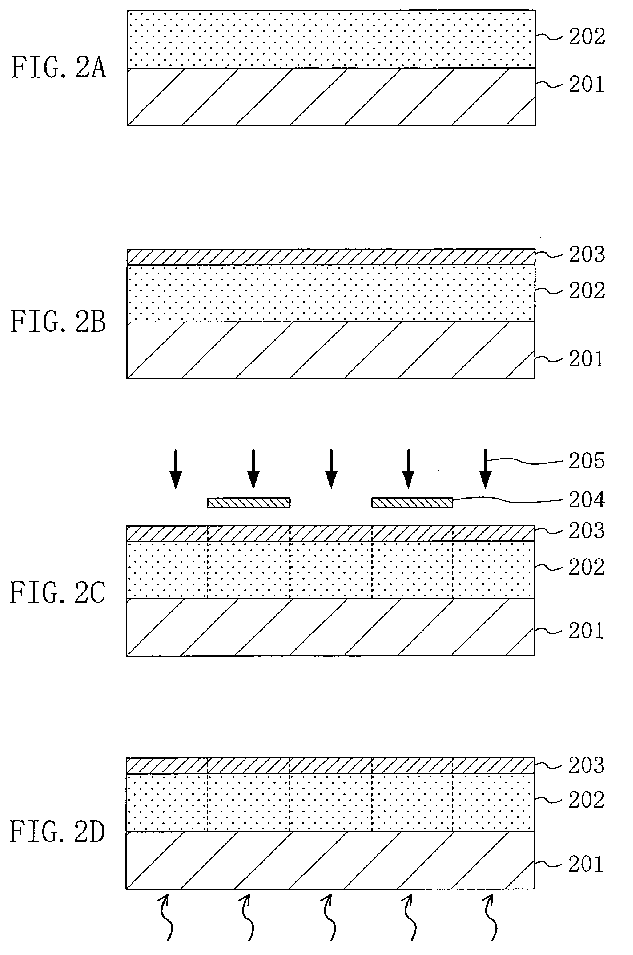

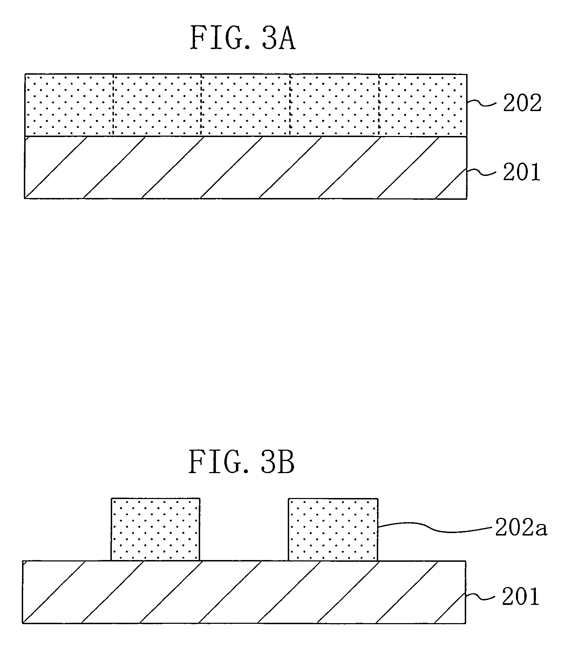

A pattern formation method using a water-soluble material according to Embodiment 2 of the invention will now be described with reference to **FIGS. 2A** through **2D, 3A** and **3B**.

First, a positive chemically amplified resist material having the following composition is prepared:
Base polymer: poly((styrenehexafluoroisopropyl alcohol) (40 mol%) - (α-trifluoromethyl-t-butylacrylate) (60 mol%)) ... 2 g
Acid generator: triphenylsulfonium triflate ... 0.08 g
Solvent: propylene glycol monomethyl ether acetate ... 20 g

Next, as shown in FIG. 2A, the aforementioned chemically amplified resist material is applied on a substrate **201** so as to form a resist film **202** with a thickness of 0.15 µm.

Subsequently, as shown in FIG. **2B,** a water-soluble film **203** with a thickness of 0.05 µm that is made of a water-soluble material having the following composition and has lower gas permeability than the resist film **202** is formed on the resist film **202** by, for example, spin coating:
Water-soluble polymer: polyvinyl pyrrolidone ... 0.6 g
Solvent: water ... 20 g

Then, as shown in FIG **2C,** pattern exposure is carried out by irradiating, through the water-soluble film **203,** the resist film **202** with exposing light **205** of F₂ laser with NA of 0.85 having passed through a mask **204.**

After the pattern exposure, as shown in FIG. **2D**, the resist film **202** is baked with a hot plate at a temperature of 110°C for 60 seconds (post exposure bake).

Next, as shown in FIG. 3A, after removing the water-soluble film 203 with water, the resultant resist film **202** is developed with a 2.38 wt% tetramethylammonium hydroxide aqueous solution (alkaline developer). In this manner, a resist pattern **202a** made of an unexposed portion of the resist film **202** and having a line width of 0.08 µm is formed in a good shape as shown in FIG. **3B.**

In this manner, according to the pattern formation method of Embodiment 2, the water-soluble film 203 made of the water-soluble polymer (i.e., polyvinyl pyrrolidone) with lower gas permeability than the chemically amplified resist used for forming the resist film **202** is formed on the resist film 202 before the pattern exposure as shown in FIG. **2B.** Therefore, in the step of pattern exposure shown in FIG. **2C**, a gas outgassed from the resist film **202** is captured by the water-soluble film **203**. Accordingly, the gas is not adhered onto a lens and a mirror included in an exposure system (not shown), the mask **204** and the like, resulting in forming the fine resist pattern **202a** in a good shape.

The water-soluble polymer used for the water-soluble film 203 is not limited to polyvinyl pyrrolidone but at least one of polyvinyl pyrrolidone, polyacrylic acid, polystyrenesulfonic acid, hydroxyethyl cellulose, polyisoprenesulfonic acid and pullulan may be used.

Furthermore, at least one of these water-soluble polymers may be included in the resist material as in Embodiment 1.

### EMBODIMENT 3

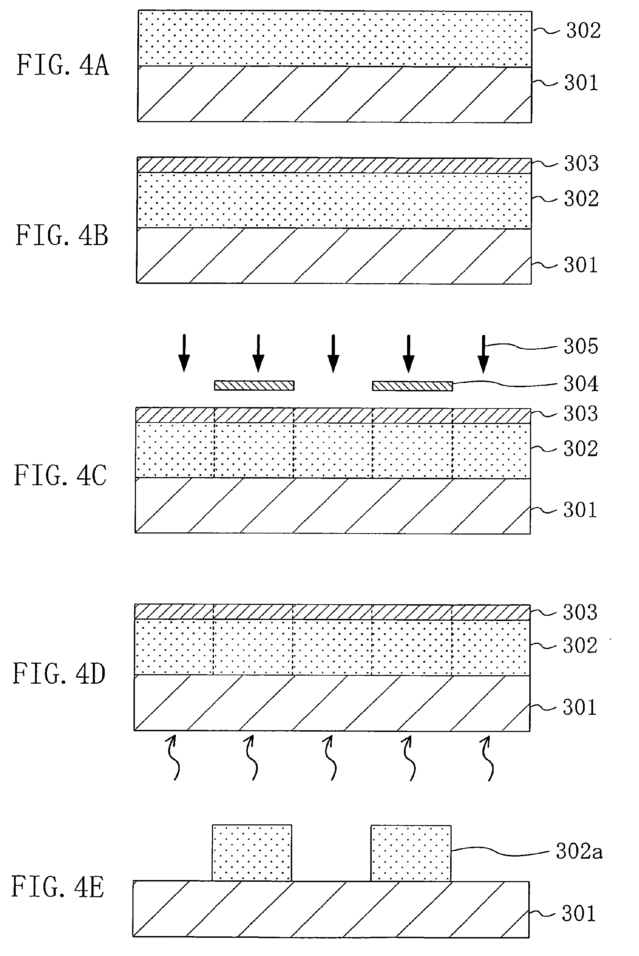

A pattern formation method using a water-soluble material according to Embodiment 3 of the invention will now be described with reference to FIGS. 4A through **4E.**

First, a positive chemically amplified resist material having the following composition is prepared:
Base polymer: poly((styrenehexafluoroisopropyl alcohol) (40 mol%) - (α-trifluoromethyl-t-butylacrylate) (60 mol%)) ... 2 g
Acid generator: triphenylsulfonium triflate ... 0.08 g
Solvent: propylene glycol monomethyl ether acetate ... 20 g

Next, as shown in FIG. **4A**, the aforementioned chemically amplified resist material is applied on a substrate **301** so as to form a resist film **302** with a thickness of 0.15 µm.

Subsequently, as shown in FIG. **4B,** a water-soluble film **303** with a thickness of 0.05 µm that is made of a water-soluble material having the following composition and has lower gas permeability than the resist film **302** is formed on the resist film **302** by, for example, the spin coating:
Water-soluble polymer: hydroxyethyl cellulose ... 0.5 g
Solvent: water ... 20 g

Then, as shown in FIG. 4C, pattern exposure is carried out by irradiating, through the water-soluble film **303,** the resist film **302** with exposing light **305** of F₂ laser with NA of 0.85 having passed through a mask **304.**

After the pattern exposure, as shown in FIG. **4D**, the resist film **302** is baked with a hot plate at a temperature of 110°C for 60 seconds (post exposure bake).

Next, the water-soluble film **303** is removed and the resultant resist film **302** is developed with a 2.38 wt% tetramethylammonium hydroxide aqueous solution (alkaline developer). In this manner, a resist pattern **302a** made of an unexposed portion of the resist film **302** and having a line width of 0.08 µm is formed in a good shape as shown in FIG. **4E.**

In this manner, according to the pattern formation method of Embodiment 3, the water-soluble film **303** made of the water-soluble polymer (i.e., hydroxyethyl cellulose) with lower gas permeability than the chemically amplified resist used for forming the resist film **302** is formed on the resist film **302** before the pattern exposure as shown in FIG. **4B.** Therefore, in the step of pattern exposure shown in FIG. **4C,** a gas outgassed from the resist film **302** is captured by the water-soluble film **303**. Accordingly, the gas is not adhered onto a lens and a mirror included in an exposure system (not shown), the mask **304** and the like, resulting in forming the fine resist pattern **302a** in a good shape.

The water-soluble polymer used for the water-soluble film **303** is not limited to hydroxyethyl cellulose but at least one of hydroxyethyl cellulose, polyacrylic acid, polystyrenesulfonic acid, polyisoprenesulfonic acid, polyvinyl pyrrolidone and pullulan may be used.

Furthermore, at least one of these water-soluble polymers may be included in the resist material as in Embodiment 1.

Although F₂ laser is used as the exposing light in each of Embodiments 1 through 3, KrF excimer laser, ArF excimer laser, ArKr laser, Ar₂ laser, extreme UV of a wavelength band not shorter than 1 nm and not longer than 30 nm or electron means may be used as the exposing light instead.

### EMBODIMENT 4

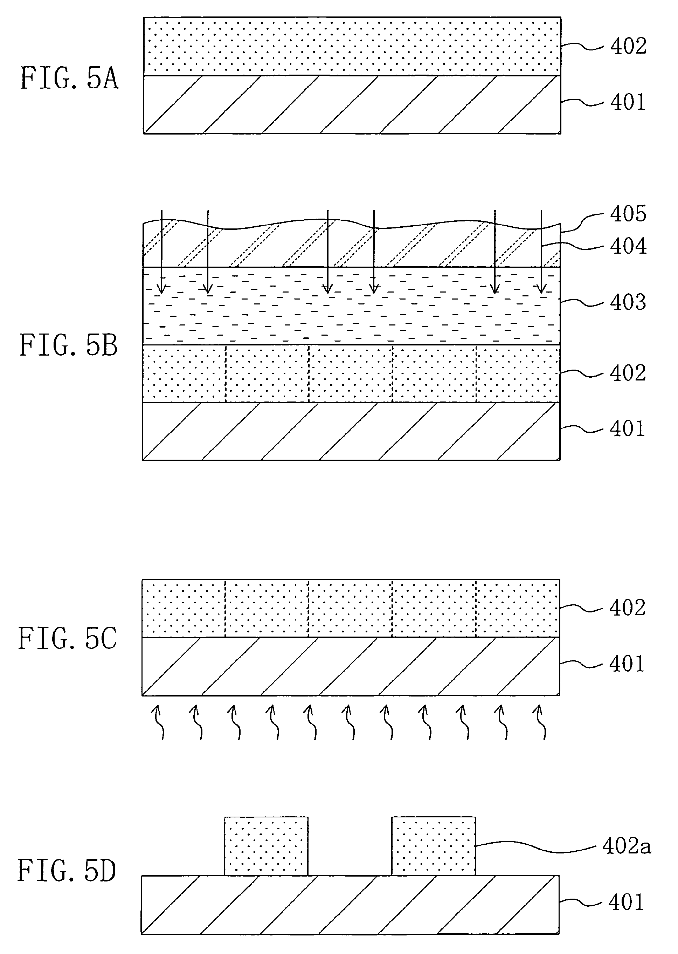

A pattern formation method using a water-soluble material according to Embodiment 4 of the invention will now be described with reference to FIGS. **5A** through **5D**.

First, a positive chemically amplified resist material having the following composition is prepared:
Base polymer: poly((norbomene-5-methylene-t-butylcarboxylate) (50 mol%) - (maleic anhydride) (50 mol%)) ... 2 g
Water-soluble polymer: polyvinyl pyrrolidone ... 0.1 g
Acid generator: triphenylsulfonium triflate ... 0.06 g
Solvent: propylene glycol monomethyl ether acetate ... 20 g

Next, as shown in FIG. **5A**, the aforementioned chemically amplified resist material is applied on a substrate **401** so as to form a resist film **402** with a thickness of 0.35 µm.

Subsequently, as shown in FIG. **5B**, with an immersion liquid **403** of water provided between the resist film **402** and a projection lens **405** by, for example, a puddle method, pattern exposure is carried out by irradiating the resist film **402** with exposing light **404** of ArF excimer laser with NA of 0.65 through a mask (not shown).

After the pattern exposure, as shown in FIG. **5C,** the resist film **402** is baked with a hot plate at a temperature of 105°C for 60 seconds (post exposure bake).

Next, the resultant resist film **402** is developed with a 2.38 wt% tetramethylammonium hydroxide aqueous solution (alkaline developer). In this manner, a resist pattern **402a** made of an unexposed portion of the resist film **402** and having a line width of 0.09 µm is formed in a good shape as shown in FIG. **5D.**

In this manner, according to the pattern formation method of Embodiment 4, in the step of forming the resist film shown in FIG. 5A, the resist material used for forming the resist film **402** includes polyvinyl pyrrolidone with lower gas permeability than the chemically amplified resist excluding the water-soluble polymer (i.e., polyvinyl pyrrolidone). Therefore, in the step of pattern exposure through the liquid **403** shown in FIG. **5B**, a gas outgassed from the resist film **402** is captured in the resist film **402.** Accordingly, foams derived from outgassing is not formed in the liquid **403** provided on the resist film **402**, and hence, the exposing light **404** is free from influence of the foams such as diffraction, resulting in forming the fine resist pattern **402a** in a good shape.

The water-soluble polymer included in the chemically amplified resist is not limited to polyvinyl pyrrolidone but at least one of polyvinyl pyrrolidone, polyacrylic acid, polystyrenesulfonic acid, hydroxyethyl cellulose, polyisoprenesulfonic acid and pullulan may be used.

Furthermore, the immersion liquid **403** of water may include an appropriate amount of surface active agent. Also, the liquid **403** is not limited to water by may be perfluoropolyether instead.

### EMBODIMENT 5

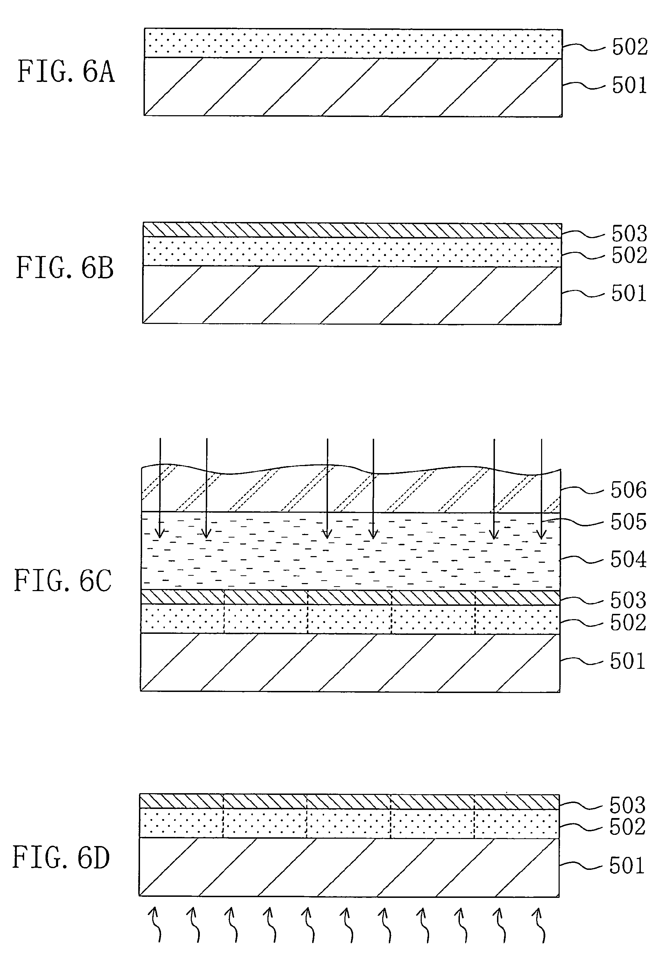

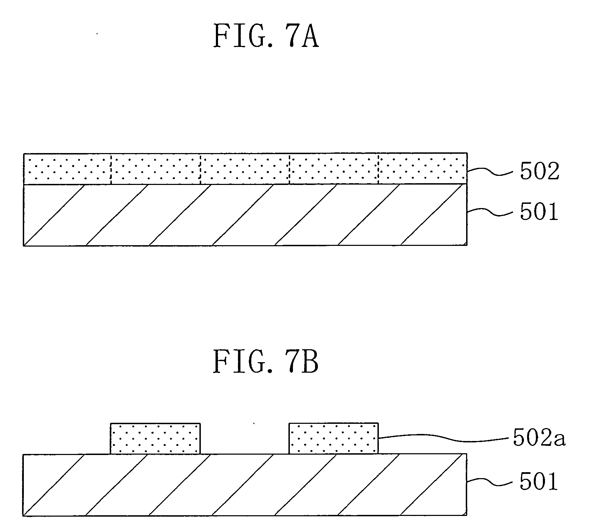

A pattern formation method using a water-soluble material according to Embodiment **5** of the invention will now be described with reference to FIGS. **6A** through **6D, 7A** and **7B**.

First, a positive chemically amplified resist material having the following composition is prepared:
Base polymer: poly((styrenehexafluoroisopropyl alcohol) (40 mol%) - (α-trifluoromethyl-t-butylacrylate) (60 mol%)) ... 2 g
Acid generator: triphenylsulfonium triflate ... 0.08 g
Solvent: propylene glycol monomethyl ether acetate ... 20 g

Next, as shown in FIG. **6A**, the aforementioned chemically amplified resist material is applied on a substrate **501** so as to form a resist film **502** with a thickness of 0.15 µm.

Then, as shown in FIG. **6B,** a water-soluble film **503** with a thickness of 0.05 µm that is made of a water-soluble material having the following composition and has lower gas permeability than the resist film **502** is formed on the resist film **502** by, for example, the spin coating:
Water-soluble polymer: polyvinyl pyrrolidone ... 0.6 g
Solvent: water ... 20 g

Subsequently, as shown in FIG. **6C**, with an immersion liquid **504** of perfluoropolyether provided between the water-soluble film **503** and a projection lens **506** by, for example, the puddle method, pattern exposure is carried out by irradiating the resist film **502** with exposing light **505** of F₂ laser with NA of 0.85 through a mask (not shown).

After the pattern exposure, as shown in FIG. **6D,** the resist film **502** is baked with a hot plate at a temperature of 110°C for 60 seconds (post exposure bake).

Next, after removing the water-soluble film **503** with water as shown in FIG. **7A,** the resultant resist film **502** is developed with a 2.38 wt% tetramethylammonium hydroxide aqueous solution (alkaline developer). In this manner, a resist pattern **502a** made of an unexposed portion of the resist film **502** and having a line width of 0.08 µm is formed in a good shape as shown in FIG. **7B**.

In this manner, according to the pattern formation method of Embodiment 5, the water-soluble film **503** made of the water-soluble material (i.e., polyvinyl pyrrolidone) with lower gas permeability than the chemically amplified resist used for forming the resist film **502** is formed on the resist film **502** before the pattern exposure as shown in FIG. **6B**. Therefore, in the step of pattern exposure through the liquid **504** shown in FIG. 6C, a gas outgassed from the resist film **502** is captured by the water-soluble film **503.** Accordingly, foams derived from outgassing is not formed in the liquid **504** provided on the water-soluble film **503,** and hence, the exposing light **505** is free from influence of the foams such as diffraction, resulting in forming the fine resist pattern **502a** in a good shape.

The water-soluble polymer included in the water-soluble film **503** is not limited to polyvinyl pyrrolidone but at least one of polyvinyl pyrrolidone, polyacrylic acid, polystyrenesulfonic acid, hydroxyethyl cellulose, polyisoprenesulfonic acid and pullulan may be used.

Furthermore, at least one of the water-soluble polymers may be included in the resist material as in Embodiment 4.

### EMBODIMENT 6

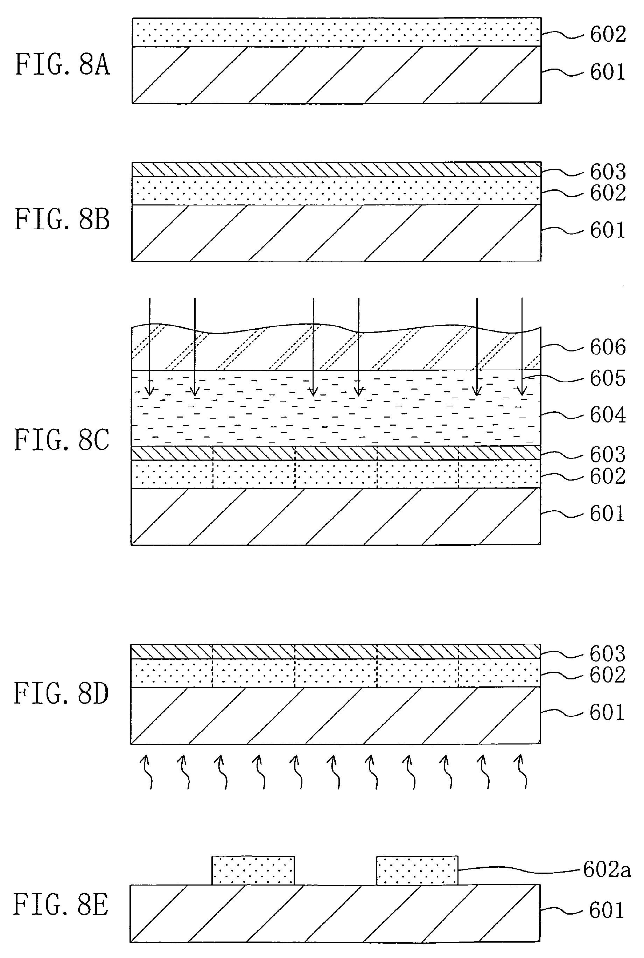

A pattern formation method using a water-soluble material according to Embodiment 6 of the invention will now be described with reference to FIGS. **8A** through **8E**.

First, a positive chemically amplified resist material having the following composition is prepared:
Base polymer: poly((styrenehexafluoroisopropyl alcohol) (40 mol%) - (α-trifluoromethyl-t-butylacrylate) (60 mol%)) ... 2 g
Acid generator: triphenylsulfonium triflate ... 0.08 g
Solvent: propylene glycol monomethyl ether acetate ... 20 g

Next, as shown in FIG. **8A**, the aforementioned chemically amplified resist material is applied on a substrate **601** so as to form a resist film **602** with a thickness of 0.15 µm.

Then, as shown in FIG. **8B**, a water-soluble film **603** with a thickness of 0.06 µm that is made of a water-soluble material having the following composition and has lower gas permeability than the resist film **602** is formed on the resist film **602** by, for example, the spin coating:
Water-soluble polymer: hydroxyethyl cellulose ... 0.5 g
Solvent: water ... 20 g

Subsequently, as shown in FIG. **8C**, with an immersion liquid **604** of perfluoropolyether provided between the water-soluble film **603** and a projection lens **606** by, for example, the puddle method, pattern exposure is carried out by irradiating the resist film **602** with exposing light **605** of F₂ laser with NA of 0.85 through a mask (not shown).

After the pattern exposure, as shown in FIG. **8D,** the resist film **602** is baked with a hot plate at a temperature of 110°C for 60 seconds (post exposure bake).

Next, the water-soluble film **603** is removed and the resultant resist film 602 is developed with a 2.38 wt% tetramethylammonium hydroxide aqueous solution (alkaline developer). In this manner, a resist pattern **602a** made of an unexposed portion of the resist film **602** and having a line width of 0.08 µm is formed in a good shape as shown in FIG. **8E.**

In this manner, according to the pattern formation method of Embodiment 6, the water-soluble film **603** made of the water-soluble material (i.e., hydroxyethyl cellulose) with lower gas permeability than the chemically amplified resist used for forming the resist film **602** is formed on the resist film **602** before the pattern exposure as shown in FIG. **8B.** Therefore, in the step of pattern exposure through the liquid **604** shown in FIG. **8C,** a gas outgassed from the resist film **602** is captured by the water-soluble film **603.** Accordingly, foams derived from outgassing is not formed in the liquid **604** provided on the water-soluble film **603**, and hence, the exposing light **605** is free from influence of the foams such as diffraction, resulting in forming the fine resist pattern **602a** in a good shape.

The water-soluble polymer included in the water-soluble film **603** is not limited to hydroxyethyl cellulose but at least one of hydroxyethyl cellulose, polyacrylic acid, polystyrenesulfonic acid, polyisoprenesulfonic acid, polyvinyl pyrrolidone and pullulan may be used.

Furthermore, at least one of the water-soluble polymers may be included in the resist material as in Embodiment 4.

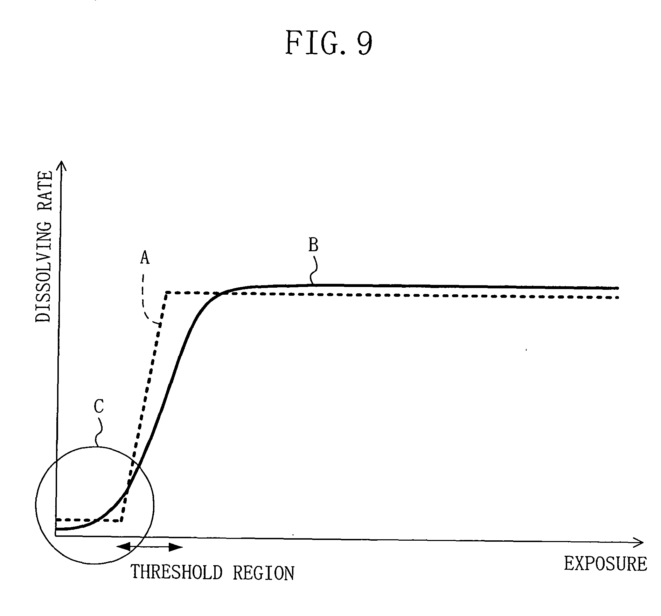

In Embodiments 3 and 6, the water-soluble films **303** and **603** are removed during the development, namely, with the developer, differently from Embodiments 2 and 5. Thus, the dissolving characteristic of the resist films **302** and **602** can be controlled. The control of the dissolving characteristic will now be described with reference to FIG. **9**.

In general, when the dissolving characteristic of a resist in a developer is high, the dissolving rate is abruptly increased when exposure exceeds a given threshold value as shown with a graph A of a broken line in FIG. **9**. As the change of the dissolving rate against the exposure is more abrupt, a difference in the solubility between an exposed portion and an unexposed portion of the resist film **302** or **602** is larger, and hence, higher resolution can be attained, namely, the resist pattern **302a** or **602a** can be formed in a better shape. Accordingly, in the case where the water-soluble film **303** or **603** is removed simultaneously with the development, the dissolving rate is wholly lowered during the removal of the water-soluble film **303** or **603** as shown with a graph **B** of a solid line in FIG. **9**, and hence, the change in a portion surrounded with a circle **C** in the graph **B** can be reduced to be approximated to a flat portion of the graph **A**. As a result, in the case where the actual resist has the dissolving characteristic as shown with the graph **B**, the dissolving rate attained with smaller exposure can be adjusted to attain a comparatively constant solution state with small exposure and a low dissolving rate within a given range. Accordingly, the difference in the solubility between an exposed portion and an unexposed portion of the resist film **302** or **602** can be substantially increased, resulting in easily forming a resist pattern in a good shape.

Although the exposing light is ArF excimer laser in Embodiment 4 and is F₂ laser in Embodiments 5 and 6, the exposing light is not limited to the ArF excimer laser and the F₂ laser but may be KrF excimer laser, F₂ laser, ArKr laser or Ar₂ laser.

Although the liquid is supplied onto the resist film or the water-soluble film by the puddle method in each of Embodiments 4 through 6, the method for supplying the liquid is not limited to the puddle method but may be, for example, a dip method in which the whole substrate is dipped in the liquid.

Furthermore, in each of Embodiments 2, 3, 5 and 6, the water-soluble film provided on the resist film also has an effect to prevent reflection (to prevent multiple beam interference).

A positive chemically amplified resist is used as the resist material in each embodiment, which does not limit invention, and the present invention is also applicable to a negative chemically amplified resist.

As described so far, in the chemically amplified resist and the pattern formation method of this invention, the trouble caused in the optical system of an exposure system and a mask by outgassing from a resist during exposure or a pattern failure derived from foams or the like formed in a liquid can be prevented. Accordingly, a resist pattern can be formed in a good shape, and hence, the invention is useful as a chemically amplified resist for use in pattern formation in fabrication process or the like for semiconductor devices and as a method for forming a fine pattern by using the chemically amplified resist.

## Claims

1. A chemically amplified resist comprising a water-soluble polymer having lower gas permeability than said chemically amplified resist excluding said water-soluble polymer.

2. The chemically amplified resist of Claim 1,
wherein said water-soluble polymer is at least one of polyacrylic acid, polystyrenesulfonic acid, hydroxyethyl cellulose, polyisoprenesulfonic acid, polyvinyl pyrrolidone and pullulan.

3. A pattern formation method comprising the steps of:
forming, on a substrate, a resist film made of a chemically amplified resist including a water-soluble polymer;
performing pattern exposure by selectively irradiating said resist film with exposing light; and
forming a resist pattern made of said resist film by developing said resist film after the pattern exposure,
wherein said water-soluble film has lower gas permeability than said chemically amplified resist excluding said water-soluble polymer.

4. A pattern formation method comprising the steps of:
forming, on a substrate, a resist film made of a chemically amplified resist;
forming, on said resist film, a water-soluble film containing a water-soluble polymer having lower gas permeability than said chemically amplified resist;
performing pattern exposure by selectively irradiating said resist film with exposing light through said water-soluble film; and
forming a resist pattern made of said resist film by developing said resist film after removing said water-soluble film after the pattern exposure.

5. A pattern formation method comprising the steps of:
forming, on a substrate, a resist film made of a chemically amplified resist;
forming, on said resist film, a water-soluble film containing a water-soluble polymer having lower gas permeability than said chemically amplified resist;
performing pattern exposure by selectively irradiating said resist film with exposing light through said water-soluble film; and
removing said water-soluble film and forming a resist pattern made of said resist film by developing said resist film after the pattern exposure.

6. A pattern formation method comprising the steps of:
forming, on a substrate, a resist film made of a chemically amplified resist including a water-soluble polymer;
performing pattern exposure by selectively irradiating said resist film with exposing light with a liquid provided on said resist film; and
forming a resist pattern made of said resist film by developing said resist film after the pattern exposure,
wherein said water-soluble polymer has lower gas permeability than said chemically amplified resist excluding said water-soluble polymer.

7. A pattern formation method comprising the steps of:
forming, on a substrate, a resist film made of a chemically amplified resist;
forming, on said resist film, a water-soluble film containing a water-soluble polymer having lower gas permeability than said chemically amplified resist;
performing pattern exposure by selectively irradiating said resist film with exposing light through said water-soluble film with a liquid provided on said water-soluble film; and
forming a resist pattern made of said resist film by developing said resist film after removing said water-soluble film after the pattern exposure.

8. A pattern formation method comprising the steps of:
forming, on a substrate, a resist film made of a chemically amplified resist;
forming, on said resist film, a water-soluble film containing a water-soluble polymer having lower gas permeability than said chemically amplified resist;
performing pattern exposure by selectively irradiating said resist film with exposing light through said water-soluble film with a liquid provided on said water-soluble film; and
removing said water-soluble film and forming a resist pattern made of said resist film by developing said resist film after the pattern exposure.

9. The pattern formation method of Claim 4,
wherein said chemically amplified resist includes a water-soluble polymer having lower gas permeability than said chemically amplified resist excluding said water-soluble polymer.

10. The pattern formation method of Claim 5,
wherein said chemically amplified resist includes a water-soluble polymer having lower gas permeability than said chemically amplified resist excluding said water-soluble polymer.

11. The pattern formation method of Claim 7,
wherein said chemically amplified resist includes a water-soluble polymer having lower gas permeability than said chemically amplified resist excluding said water-soluble polymer.

12. The pattern formation method of Claim 8,
wherein said chemically amplified resist includes a water-soluble polymer having lower gas permeability than said chemically amplified resist excluding said water-soluble polymer.

13. The pattern formation method of Claim 3,
wherein said water-soluble polymer is at least one of polyacrylic acid, polystyrenesulfonic acid, hydroxyethyl cellulose, polyisoprenesulfonic acid, polyvinyl pyrrolidone and pullulan.

14. The pattern formation method of Claim 4,
wherein said water-soluble polymer is at least one of polyacrylic acid, polystyrenesulfonic acid, hydroxyethyl cellulose, polyisoprenesulfonic acid, polyvinyl pyrrolidone and pullulan.

15. The pattern formation method of Claim 5,
wherein said water-soluble polymer is at least one of polyacrylic acid, polystyrenesulfonic acid, hydroxyethyl cellulose, polyisoprenesulfonic acid, polyvinyl pyrrolidone and pullulan.

16. The pattern formation method of Claim 6,
wherein said water-soluble polymer is at least one of polyacrylic acid, polystyrenesulfonic acid, hydroxyethyl cellulose, polyisoprenesulfonic acid, polyvinyl pyrrolidone and pullulan.

17. The pattern formation method of Claim 7,
wherein said water-soluble polymer is at least one of polyacrylic acid, polystyrenesulfonic acid, hydroxyethyl cellulose, polyisoprenesulfonic acid, polyvinyl pyrrolidone and pullulan.

18. The pattern formation method of Claim 8,
wherein said water-soluble polymer is at least one of polyacrylic acid, polystyrenesulfonic acid, hydroxyethyl cellulose, polyisoprenesulfonic acid, polyvinyl pyrrolidone and pullulan.

19. The pattern formation method of Claim 6,
wherein said liquid is water or perfluoropolyether.

20. The pattern formation method of Claim 7,
wherein said liquid is perfluoropolyether.

21. The pattern formation method of Claim 8,
wherein said liquid is perfluoropolyether.

22. The pattern formation method of Claim 3,
wherein said exposing light is KrF excimer laser, ArF excimer laser, F₂ laser, ArKr laser, Ar₂ laser, extreme UV of a wavelength band not shorter than 1 nm and not longer than 30 nm, or electron beams.

23. The pattern formation method of Claim 4,
wherein said exposing light is KrF excimer laser, ArF excimer laser, F₂ laser, ArKr laser, Ar₂ laser, extreme UV of a wavelength band not shorter than 1 nm and not longer than 30 nm, or electron beams.

24. The pattern formation method of Claim 5,
wherein said exposing light is KrF excimer laser, ArF excimer laser, F₂ laser, ArKr laser, Ar₂ laser, extreme UV of a wavelength band not shorter than 1 nm and not longer than 30 nm, or electron beams.

25. The pattern formation method of Claim 6,
wherein said exposing light is KrF excimer laser, ArF excimer laser, F₂ laser, ArKr laser or Ar₂ laser.

26. The pattern formation method of Claim 7,
wherein said exposing light is KrF excimer laser, ArF excimer laser, F₂ laser, ArKr laser or Ar₂ laser.

27. The pattern formation method of Claim 8,
wherein said exposing light is KrF excimer laser, ArF excimer laser, F₂ laser, ArKr laser or Ar₂ laser.
